# EUROPEAN PATENT APPLICATION

(11) **EP 0 538 019 A2**
(43) Date of publication of application: **21.04.1993**
(21) Application number: 92309379.3
(22) Date of filing: 14.10.1992
(51) Int. Cl.: H01L 23/495

(54) **Lead frame for a semiconductor device**

(30) Priority: 17.10.1991 JP 298219/91
(71) Applicant: SHINKO ELECTRIC INDUSTRIES CO. LTD., Nagano-shi, Nagano 380 (JP)
(72) Inventor: Murata, Akihiko, c/o SHINKO ELECTRIC IND. CO. LTD., Nagano-shi, Nagano 380 (JP); Wakabayashi, Norio, c/o SHINKO ELEC. IND. CO. LTD., Nagano-shi, Nagano 380 (JP)
(74) Representative: Rackham, Stephen Neil

(57) **Abstract**

A lead frame (10) for a semiconductor device has good corrosion resistance characteristics and is easily made at a low cost. Such a lead frame (10) comprises a base material (11) made of iron or a metal consisting essentially of iron; a copper or copper alloy plated layer (12) formed on the base material (11); a nickel, cobalt, or nickel-cobalt alloy plated layer (14) formed on the copper or copper-alloy layer (12); and a precious metal plated layer (16) having a thickness of not more than 1 µm formed on the layer (14).

## Description

This invention relates to a lead frame adapted to be used for a semiconductor device.

Particularly, this invention relates to a lead frame having good corrosion resistance characteristics that is easily made at a low cost.

A semiconductor device comprises a lead frame having a chip mounting or die-pad area with a plurality of leads around and a semiconductor chip mounted on said die-pad area including plurality of connecting terminals, metal wires for connecting tips of the respective leads to the terminals of said semiconductor chip, and a mold resin material for hermetically sealing at least a region including the semiconductor chip and the tips of the leads around the chip.

To improve the die-bonding, wire-bonding and solder-connecting characteristics in a lead frame used for a semiconductor device, it is known that the lead frame should be plated with a precious metal, such as, gold, silver or the like. Various kinds of material can be used for such a lead frame.

Iron or a metal consisting essentially of iron can be provided as a material for a lead frame at a relatively low cost. On the other hand, copper or copper alloy can be provided as such a material having good corrosion resistance characteristics.

Thus, if iron or a metal consisting essentially of iron is used as a material for a lead frame, corrosion will always occur. To improve the corrosion resistance characteristics of such a material, the thickness of a layer coated on the material should be increased. However, when a precious metal is used as a coating material, in many cases, such a metal can only be plated on the tip portions of the inner leads to improve the wire-bonding characteristics, because such a material is so expensive. As far as outer leads, another solder material is generally plated thereon to improve the soldering characteristics.

However, since a plated layer of precious metal has good soldering characteristics, it is preferable that, instead of forming another plated layer on the outer leads, a precious metal plated layer should be formed on the outer leads as well as the inner leads. In addition, it is also preferable to form the precious metal plated layer on the entire surface of the lead frame, since a partial plating is rather troublesome.

Nevertheless, since a precious metal plated layer is so expensive that costs will increase if such a plated layer is formed on the entire surface of the lead frame.

Although it is necessary to form a precious metal plated layer as thin as possible, if the material is iron or a metal consisting essentially of iron, corrosion will occur. In practice, in an acceleration test, such as a steam aging test or a salt water spraying test, it was found that the samples became rusty so that some problems occurred for example, the soldered portion deteriorated, or the lead folded. Therefore, in the prior art, if the material was iron or a metal consisting essentially of iron, a lead frame with a precious metal plated layer formed on the entire surface thereof could not be practically provided.

In particular, if a precious metal plated layer that is formed on the lead frame material of iron or a metal consisting essentially of iron has a large voltage difference with respect to the lead frame material, electro corrosion will be generated through pin holes owing to the voltage difference between the two materials, and the material will rust more easily.

According to this invention a lead frame for a semiconductor device comprises:
a lead frame base material made of iron or a metal consisting essentially of iron;
a first plated layer made of copper or copper alloy formed on said lead frame base material;
a second plated layer made of nickel, cobalt, or nickel-cobalt alloy layer formed on said first plated layer; and
a third plated layer made of precious metal having a thickness of not more than 1 µm formed on said second plated layer.

Such a lead frame has good corrosion resistance characteristics, in spite of the lead frame material being iron or a metal consisting essentially of iron and also includes a precious metal plated layer is formed on the entire surface of the lead frame and which is both stable and inexpensive.

In the present invention, a lead frame having good corrosion resistance characteristics can be obtained, because the first plated layer serves to prevent a generation of corrosion, such as rust, the second plated layer serves to prevent a dispersion of the copper of the first plated layer, and thus both the first and second plated layers cooperate to provide a lead frame having good corrosion resistance characteristics and a good inherent property regarding the precious metal plated layer.

A particular embodiment of a lead frame in accordance with this invention will now be described with reference to the accompanying drawings, in which:-
Figure 1 is a plan view of a lead frame according to the present invention; and
Figure 2 is an enlarged cross-sectional view of the lead frame of the present invention shown in Fig. 1.

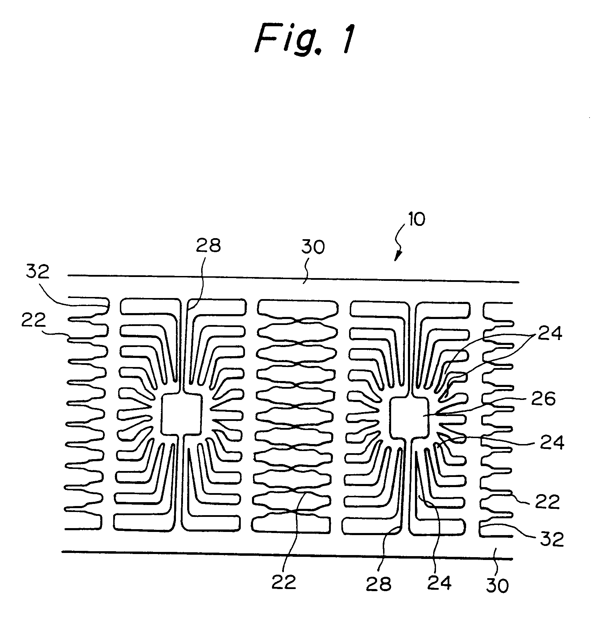

Referring now to Fig. 1, a lead frame generally indicated by reference numeral 10 is made of a metal strip, including outer leads 22, inner leads 24, and a chip mounting area or die pad 26, on which a semiconductor chip (not shown) is to be mounted, which are supported and connected via support bars 18 to upper and lower guide rails 30. A reference numeral 32 indicates dam bars.

After certain metal films are formed on the surface of the lead frame 10, as will be described hereinafter in detail, a semiconductor chip (not shown) is mounted on the chip mounting area 26, the semiconductor chip is connected to the inner leads by bonding wires and, then, the semiconductor device including at least the semiconductor chip and the inner leads around the chip is hermetically sealed with a mold resin material, thereby obtaining a semiconductor device.

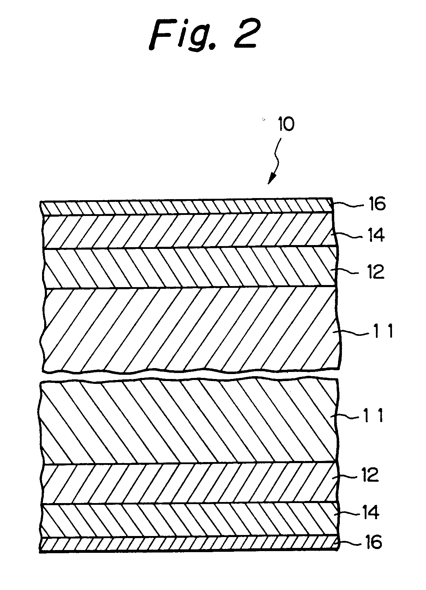

In Fig. 2, the material of the lead frame may be iron, iron-nickel alloy, or iron-nickel-cobalt alloy. According to this invention, on the entire surface of the lead frame 10 a first plated layer 12 a second plated layer 14, and a third plated layer 16 are formed. The first plated layer 12 is made of copper or copper alloy. It is not necessary to specifically limit the thickness of the first plated layer 12. It is preferable, however, that the thickness of the first plated layer 12 be not less than 1 µm and more preferably 3 to 4 µm.

The second plated layer 14 is made of nickel, cobalt, or nickel-cobalt alloy. It is preferable that the thickness of the second plated layer 14 be not less than 0.5 µm.

The third plated layer 16 is made of a precious metal, such as palladium, gold, or silver. It is preferable that the thickness of the second plated layer 14 be not more than 1 µm, and more preferably 0.03 to 0.1 µm.

In particular, it is preferable that the third plated layer 16 be made of palladium. If gold was used as the third plated layer, after the outer leads were soldered, gold-tin alloy, which is weak in strength, might be formed between the gold and solder material. In addition, if silver was used as the third plated layer, migration (so-called) may occur and it would affect the insulation characteristics of the leads if the gaps between the leads were small. Therefore, palladium is particularly suitable as a precious metal for the third plated layer 16.

According to the embodiment as mentioned above, the following advantages can be obtained by forming three metal plated layers on the lead frame.

As mentioned above, according to the prior art, a precious metal plated layer was formed directly on the lead frame material made of iron or a metal consisting essentially of iron. A large voltage difference thus existed between the precious metal plated layer and the base material and electro corrosion occurred through the pin holes or the like if moisture existed, and the material rusted. According to the present invention, however, since a first plated layer 12 exists between the precious metal plated layer and the base material, the first plated layer 12, i.e., copper or copper alloy, moderates the above-mentioned voltage difference and thereby preventing electric corrosion on the base material.

If, however, there is a copper or copper plated layer under the precious metal plated layer, and the precious metal plated layer is very thin, the copper may disperse into the upper precious metal layer. Thus, the precious metal layer would deteriorate and soldering characteristics would deteriorate. To solve such a problem, according to the present invention, a second metal plated layer 14 is formed between the first plated layer 12 and the precious metal plated layer.

Thus, according to the present invention, the first plated layer 12 serves to prevent corrosion, such as rust, and the second plated layer 14 serves to prevent dispersion of the copper of the first plated layer 12. Thus, both the first and second plated layers 12 and 14 cooperate to provide a lead frame having good corrosion resistance characteristics and a good inherent property regarding the precious metal plated layer.

### Embodiment 1

Some samples of the first embodiment were made as follows: 42-alloy (iron-nickel alloy) was used as the lead frame base material; a first metal plated layer made of copper and having a thickness of 3 µm was formed on the base material; a second metal plated layer made of nickel and having a thickness of 1.5 µm was formed on the first plated layer; and a palladium plated layer having 0.1 µm was formed as the uppermost plated layer. On the contrary, some samples that were the same as above, excepting the omission of a first plated layer, were prepared as comparative examples.

The above mentioned samples were subjected to a salt water spraying test for 24 hours using 3% salt water. Regarding the embodiment samples, a generation of rust could not be found and good corrosion resistance characteristics could be recognized. On the contrary, in the samples of the comparative example, a generation of a significant amount of rust and folded leads could be found.

Similar results as mentioned above could also be obtained when a cobalt plated layer or a nickel-cobalt alloy plated layer was formed as the second plated layer.

### Embodiment 2

In the second embodiment, 42-alloy was used as the lead frame base material in the same manner as the first embodiment. But the thickness of a first metal plated layer made of copper was 2 µm and the thickness of a second metal plated layer made of nickel was 1 µm. A gold plated layer having 0.05 µm was formed as the uppermost plated layer. As a comparative example, some samples were prepared with a gold-plated layer having a thickness of 0.05 µm.

These samples were subjected to a steam aging test for 8 hours. Regarding embodiment samples, a generation of rust could not be found and good corrosion resistance characteristics could be recognized. In the comparative example, a generation of a significant amount of rust could be found and the soldering characteristics were much worse than those of the embodiment.

As mentioned above, according to the present invention, even if the thickness of the precious metal plated layer is greatly reduced for the purpose of cost reduction, electric corrosion can effectively be prevented from occurring through pin holes. Thus, the lead frame has good corrosion resistance characteristics, prevents dispersion of copper, and has good soldering characteristics. Therefore, even after the lead frame is heated, good wire-bonding and soldering characteristics can be maintained.

## Claims

1. A lead frame (10) adapted to be used for a semiconductor device comprising:
a lead frame base material (11) made of iron or a metal consisting essentially of iron;
a first plated layer (12) made of copper or copper alloy formed on said lead frame base material (11);
a second plated layer (14) made of nickel, cobalt, or nickel-cobalt alloy layer formed on said first plated layer (12); and
a third plated layer (16) made of precious metal having a thickness of not more than 1 µm formed on said second plated layer (14).

2. A lead frame according to claim 1, wherein said first (12), second (14) and third (16)plated layers are formed on the entire surfaces of said lead frame base material (11).

3. A lead frame according to claim 1 or 2, wherein said precious metal plated layer is made of palladium.

4. A lead frame according to claim 2, wherein said palladium metal plated layer has a thickness of not more than 0.1 µm.
